(19)

Europäisches Patentamt
European Patent Office
Office européen des brevets

(11) EP 4 322 356 A1

(12) EUROPEAN PATENT APPLICATION
published in accordance with Art. 153(4) EPC

(43) Date of publication:
14.02.2024 Bulletin 2024/07

(51) International Patent Classification (IPC):
H02H 9/04 (2006.01)

(21) Application number: 22806867.2

(52) Cooperative Patent Classification (CPC):
H02H 9/04

(22) Date of filing: 13.05.2022

(86) International application number:
PCT/CN2022/092881

(87) International publication number:
WO 2022/237905 (17.11.2022 Gazette 2022/46)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 11.05.2021 CN 202110510999

(71) Applicant: Huawei Technologies Co., Ltd.
Longgang
Shenzhen, Guangdong 518129 (CN)

(72) Inventors:
• AN, Zheying
  Shenzhen, Guangdong 518129 (CN)
• CAO, Wenfei
  Shenzhen, Guangdong 518129 (CN)
• ZHAO, Zifeng
  Shenzhen, Guangdong 518129 (CN)

(74) Representative: Isarpatent
Patent- und Rechtsanwälte
Barth Hassa Peckmann & Partner mbB
Friedrichstraße 31
80801 München (DE)

(54) **VOLTAGE PROTECTION APPARATUS AND SYSTEM**

(57) This application relates to a voltage protection apparatus and a system. The voltage protection apparatus includes: at least one varistor connected in series to and between a signal reference ground of a printed circuit board and a first connector, and a high-voltage capacitor connected in series to and between the signal reference ground and a metal housing, where the first connector, the at least one varistor, and the high-voltage capacitor are fixed to the printed circuit board, and the first connector is a component for connecting the printed circuit board to an external device; and a metal housing in which a cavity configured to accommodate the printed circuit board is formed, where a distance between any position on the printed circuit board and any position on an inner surface of the metal housing is greater than or equal to an electrical safety distance. The voltage protection apparatus implements floating-ground installation of the printed circuit board, and has a shorter electrical safety distance under a same protection voltage requirement, so that a distance between the printed circuit board and the metal housing is reduced, the apparatus has low costs, good protection performance, and high reliability, and is applicable to different application scenarios and different protection voltage requirements.

FIG. 1A

**Description**

This application claims priority to Chinese Patent Application No. 202110510999.4, filed with the China National Intellectual Property Administration on May 11, 2021 and entitled "VOLTAGE PROTECTION APPARATUS AND SYSTEM", which is incorporated herein by reference in its entirety.

**TECHNICAL FIELD**

This application relates to the field of apparatus protection technologies, and in particular, to a protection apparatus and a system based on the protection apparatus.

**BACKGROUND**

In a process of using various apparatuses, a "grounding" setting usually needs to be performed. The "grounding" setting may provide a unified signal reference for the apparatuses, and may also prevent a human body from being injured due to accidental touch of an energized apparatus, and may further protect the apparatuses from being damaged due to lightning. An access network apparatus may be installed and fixed on a wall inside a building, installed and fixed on an external wall of a building, or directly placed on a ground inside a building such as an equipment room, a power distribution room, or a weak-current well. The access network apparatus may be applied to different application scenarios and may be installed at different positions. In the related technology, "grounding" of the access network apparatus may be implemented by using a specific cable or a "floating ground", but due to limitations such as a use scenario, there are problems of high costs, difficult maintenance, and high security risks.

**SUMMARY**

Therefore, a voltage protection apparatus and a system based on the voltage protection apparatus are provided.
According to a first aspect, an embodiment of this application provides a voltage protection apparatus, where the apparatus includes a metal housing, a printed circuit board, a first connector, at least one varistor, and a high-voltage capacitor, where

the at least one varistor is connected in series to and between a signal reference ground of the printed circuit board and the first connector, and the high-voltage capacitor is connected in series to and between the signal reference ground and the metal housing;
the first connector, the at least one varistor, and the high-voltage capacitor are fixed to the printed circuit board, and the first connector is a component for connecting the printed circuit board to an external device; and
a cavity configured to accommodate the printed circuit board is formed inside the metal housing, the printed circuit board is fixed in the cavity, and a distance between any position on the printed circuit board and any position on an inner surface of the metal housing is greater than or equal to an electrical safety distance.

The voltage protection apparatus provided in the first aspect implements setting of a protection ground, an antistatic ground, and a shielding ground of the apparatus, and can implement floating-ground installation of a printed circuit board. In addition, the electrical safety distance is less under the same protection voltage requirement, so that a distance between the printed circuit board and the metal housing is reduced. Therefore, a size of the printed circuit board may be greater under the same volume of the metal housing, or a size of the metal housing may be less under the same volume of the printed circuit board. In addition, the voltage protection apparatus has low cost, good protection performance, and high reliability. In addition, a corresponding user has a low requirement, so the voltage protection apparatus is easy to install and maintain, and is applicable to different application scenarios and different protection voltage level requirements.
According to the first aspect, in a first possible implementation of the apparatus, if there are a plurality of varistors, the plurality of varistors are connected in series and/or in parallel, and the plurality of varistors connected in series and/or in parallel are connected in series to and between the signal reference ground and the first connector. In this way, a quantity of varistors may be selected based on an actual requirement, and a connection manner between the plurality of varistors may be set.
According to the first aspect, in a second possible implementation of the apparatus, an equivalent clamp voltage of the at least one varistor is less than or equal to a first divided voltage on the printed circuit board, an operating voltage of the high-voltage capacitor is greater than or equal to a second divided voltage between the signal reference ground and the metal housing, and a capacitance of the high-voltage capacitor ranges from 1 nF to 10 nF. In this way, it is ensured that the voltage protection apparatus meets a corresponding protection requirement.

According to the first aspect, in a third possible implementation of the apparatus, the apparatus further includes a fastener, and a material of the fastener is a conductive material;

a protruding portion located in the cavity is disposed on the metal housing, and the fastener is configured to fasten the printed circuit board to the protruding portion; and
one end of the high-voltage capacitor is connected to the signal reference ground, and the other end of the high-voltage capacitor is disposed in an area in which the printed circuit board is in contact with the fastener, or the other end of the high-voltage capacitor extends, by using a wire, to an area in which the printed circuit board is in contact with the fastener, so that the other end of the high-voltage capacitor is indirectly connected to the metal housing by using the fastener.

In the third possible implementation of the first aspect, the other end of the high-voltage capacitor may be connected to the metal housing by using the fastener, and there is no need to separately dispose a "wire" for implementing the connection between the other end of the high-voltage capacitor and the metal housing, thereby reducing costs of the apparatus and simplifying structural setting of the apparatus. In addition, compared with the separately disposed "wire", the fastener has higher reliability, and can further improve reliability of the apparatus.

According to the third possible implementation of the first aspect, in a fourth possible implementation of the apparatus, the fastener includes a screw or a bolt, a through hole is provided on the printed circuit board, and an inner wall of the through hole is covered with a conductive layer; a screw hole or a bottom hole is provided on the protruding portion, and the screw or the bolt is screwed into the screw hole or the bottom hole through the through hole; and the other end of the high-voltage capacitor is connected to the conductive layer directly or by using the wire, so that the other end of the high-voltage capacitor is indirectly connected to the metal housing by using the conductive layer and the fastener. In this way, the printed circuit board is fixed and the other end of the high-voltage capacitor is connected to the metal housing by using the screw or the bolt. The bolt or the screw is more convenient for the user to install and remove the printed circuit board. In addition, the "bolt or screw" and the "through hole with a conductive layer disposed on the printed circuit board" are disposed, which further simplifies the structure setting of the apparatus. Because the bolt and the screw can be processed and manufactured by using an existing processing process, a manufacturing process of the apparatus can be simplified.

According to the first aspect, in a fifth possible implementation of the apparatus, the first connector includes at least one network port connector and/or at least one plain old telephone service connector. In this way, it can be ensured that all connectors that may be affected by a surge voltage can be protected.

According to the first aspect, in a sixth possible implementation of the apparatus, a connection line hole communicating with the cavity is provided on the metal housing, so that a connection line of the external device connected to the printed circuit board is connected to the first connector through the connection line hole.

According to the first aspect or any possible implementation of the first aspect, in a seventh possible implementation of the apparatus, the metal housing includes a body and a cover body, where

when the cover body is in a closed state relative to the body, the cover body and the body form the sealed cavity inside; and
when the cover body is in an open state relative to the body, at least the first connector is located in an operable space relative to the body, where the operable space includes an external space relative to the body and/or an internal space of the body, so as to facilitate a connection between the external device and the first connector in the operable space.

In the sixth possible implementation of the first aspect, the metal housing is disposed as two parts: a cover body and a body, and the user may open or close the metal housing by performing an operation on the cover body, to perform operations such as maintaining the voltage protection apparatus and connecting to an external device.

According to the seventh possible implementation of the first aspect, in an eighth possible implementation of the apparatus, the body is provided with the connection line hole and/or the protruding portion. In this way, after the user opens the metal housing, the portions that can be maintained and operated by the user, such as the printed circuit board, are all located in the body, so that the user can conveniently use and maintain the voltage protection apparatus.

According to a second aspect, an embodiment of this application provides a system based on a voltage protection apparatus, including:

the voltage protection apparatus according to the first aspect or any possible implementation of the first aspect; and
an external device, where the external device is connected to the printed circuit board of the voltage protection apparatus by using the first connector of the voltage protection apparatus.

According to the second aspect, in a first possible implementation of the system, a connection line of the external device is connected to the first connector through the connection line hole of the voltage protection apparatus.

These aspects and other aspects of this application are more concise and more comprehensive in descriptions of the following (a plurality of) embodiments.

**BRIEF DESCRIPTION OF DRAWINGS**

Accompanying drawings included in this specification and constituting a part of this specification and this specification jointly show example embodiments, features, and aspects of this application, and are intended to explain principles of this application.

FIG. 1A and FIG. 1B are schematic structural diagrams of a voltage protection apparatus according to an embodiment of this application.
FIG. 2 is a schematic diagram of circuit connection of a voltage protection apparatus according to an embodiment of this application.
FIG. 3 is a main view of a PCB according to an embodiment of this application.
FIG. 4 is a cross-sectional view of a voltage protection apparatus according to an embodiment of this application.
FIG. 5 is a schematic structural diagram of a system based on a voltage protection apparatus according to an embodiment of this application.
FIG. 6A and FIG. 6B are schematic structural diagrams of a protruding portion according to an embodiment of this application.

**DESCRIPTION OF EMBODIMENTS**

The following describes various example embodiments, features, and aspects of this application in detail with reference to the accompanying drawings. Identical reference numerals in the accompanying drawings indicate elements that have same or similar functions. Although various aspects of embodiments are illustrated in the accompanying drawing, the accompanying drawings are not necessarily drawn in proportion unless otherwise specified.

A specific term "example" herein means "used as an example, embodiment or illustration". Any embodiment described as "example" is not necessarily explained as being superior or better than other embodiments.

In addition, to better describe this application, numerous specific details are given in the following specific implementations. A person skilled in the art should understand that this application can also be implemented without some specific details. In some embodiments, methods, means, elements, and circuits that are well-known to a person skilled in the art are not described in detail, so that a subject matter of this application is highlighted.

An access network apparatus in the related technology has two "grounding" implementations:

Manner 1: A connection point used for "grounding" is disposed on a housing of the access network apparatus, and then a specific cable is directly connected to the connection point, so as to implement "grounding" by using the specific cable. However, in the manner 1, the access network apparatus needs to specially set a connection point used for "grounding", which increases the design cost of the access network apparatus. Second, additional material costs are increased by using the specific cable. In addition, because the specific cable is set, the apparatus is limited to be applicable only to a specific application scenario, and a relatively high requirement is imposed on an installation site. Third, the installation personnel of the access network apparatus need to have a relatively high installation and maintenance capability (replace the specific cable, and periodically determine whether "grounding" based on the specific cable is normal), and after installation, the installation personnel need to perform regular maintenance, which increases the installation cost. However, due to the foregoing three reasons, the access network apparatus that implements "grounding" by using the manner 1 is widely not grounded. After installation, problems such as poor grounding or grounding failure, bring inestimable hidden troubles to the safety of the person and the apparatus, and even bring fire hazards to the building where the apparatus is installed.

Manner 2: The access network apparatus performs "floating" setting. The "ground" in the floating ground (floating ground) is an equipotential point or a plane of a circuit or a system reference. "Floating ground" means that a signal inside an apparatus and an apparatus ground are not grounded. To implement "floating ground", an insulation film layer is added. For example, an insulation layer is sprayed on a housing of the apparatus, and an insulation film is disposed on a printed circuit board of the apparatus or a component that needs to be protected. In addition, to meet a protection requirement, density of the insulation film layer and insulation performance of the insulation film layer need to be ensured, so as to meet protection requirements of different protection specifications. In this way, costs of the apparatus are increased, and costs are greatly increased when a protection requirement is relatively high. In addition, the insulation film layer is vulnerable to damage under external force, a requirement on an installation site of the apparatus is relatively high, and requirements of different application scenarios of the apparatus cannot be met. Alternatively, in order to implement "floating ground", a spacing between the printed circuit board, the component, and the housing of the apparatus is increased with the increasing requirement of the protection voltage. However, the manner of increasing the spacing may result in an expansion of the range of a keep-out area (keep-out area) of the printed circuit board in the apparatus. This is because due to various requirements such as installation of a mechanical part or a specific component, fixing of the printed circuit board, insertion and removal of the printed circuit board, and limitation of an installation environment on the printed circuit board, it is necessary to limit the area of wiring and component layout on the surface or inside of the printed circuit board, and set an area in which wiring is forbidden to form a keep-out area. However, a size of a printed circuit board and an apparatus is limited. When a protection requirement is high, a manner of increasing a spacing may exceed a size limit of the apparatus and/or a product, and cannot be implemented.

It can be seen that, in the related technology, all "grounding" implementations of an access network apparatus have problems. To solve the foregoing technical problem, this application provides a voltage protection apparatus and a system based on the voltage protection apparatus. The voltage protection apparatus implements setting of a protection ground, an anti-static ground, and a shielding ground of the apparatus, and can implement floating-ground installation of a printed circuit board. In addition, the electrical safety distance is less under the same protection voltage requirement, so that a distance between the printed circuit board and the metal housing is reduced. Therefore, a size of the printed circuit board may be greater under the same volume of the metal housing, or a size of the metal housing may be less under the same volume of the printed circuit board. In addition, the voltage protection apparatus has low cost, good protection performance, and high reliability. In addition, a corresponding user has a low requirement, so the voltage protection apparatus is easy to install and maintain, and is applicable to different application scenarios and different protection voltage level requirements. The protection ground refers to that when the voltage protection apparatus is in normal use, the voltage protection apparatus is grounded, so as to provide security protection for personnel such as a user in a case of leakage of the voltage protection apparatus, lightning strike, or the like. The anti-static ground refers to that charges on the metal housing of the voltage protection apparatus can be released in time, so as to avoid adverse impact on the working of the voltage protection apparatus caused by the accumulation of the charges on the metal housing. The shielding ground refers to that the voltage protection apparatus may not be affected by an external electromagnetic environment under the action of the metal housing, so as to ensure that the voltage protection apparatus can work stably.

The voltage protection apparatus provided in this application may be used as an access network apparatus, and the printed circuit board only needs to be set based on a requirement for accessing the network, and may also be used as an apparatus with another function. In addition, the protection apparatus in this application may be installed and fixed on a wall inside a building, installed and fixed on an external wall of a building, or directly placed on a ground inside a building such as an equipment room, a power distribution room, or a weak-current well, or may be placed on a plane such as a desktop.

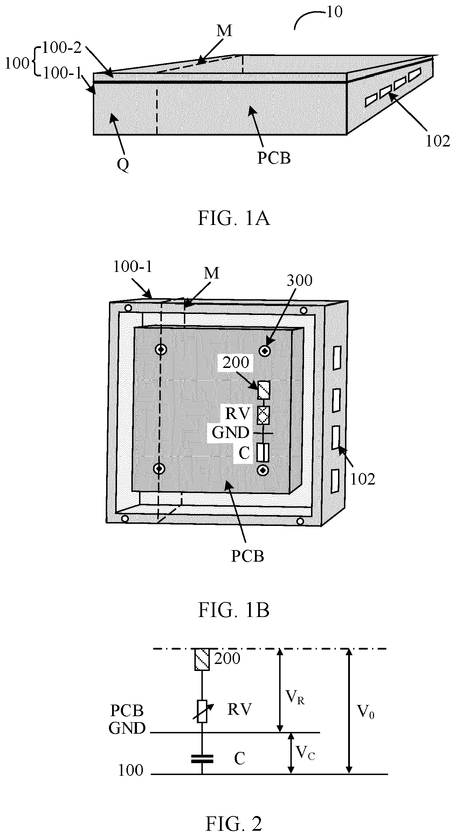

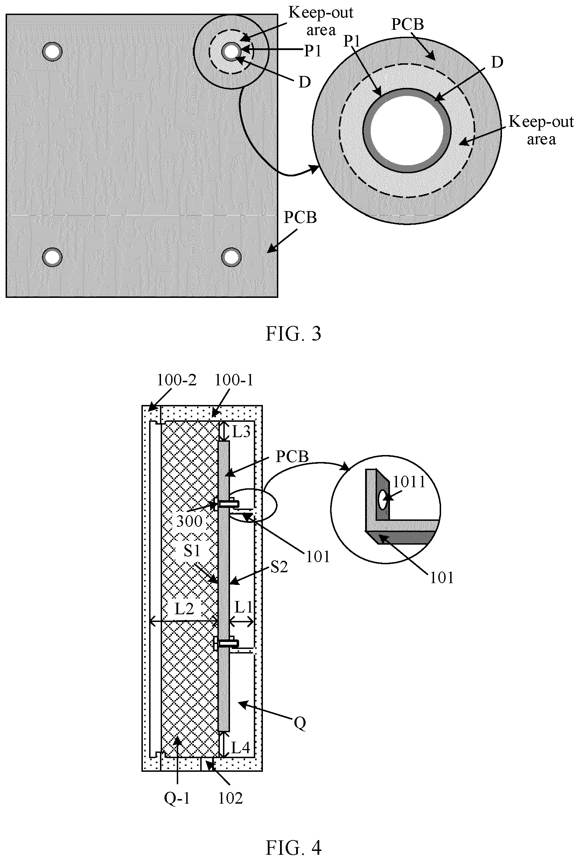

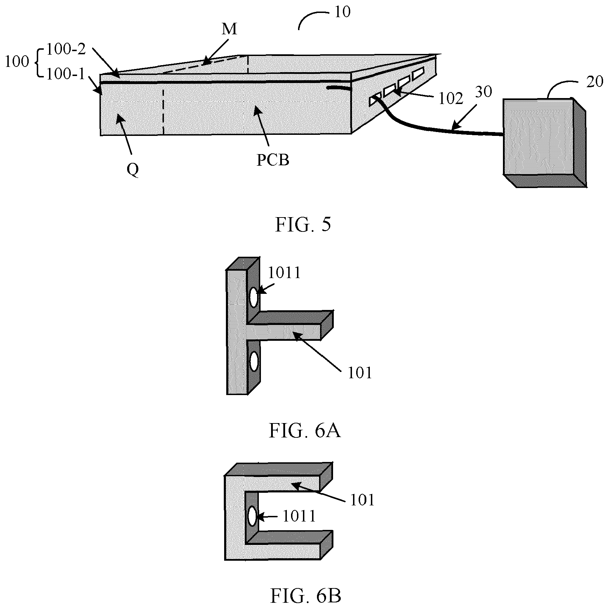

To describe a voltage protection apparatus and a system based on the voltage protection apparatus provided in this application, the following provides descriptions with reference to examples shown in FIG. 1A, FIG. 1B, and FIG. 2 to FIG. 5 in this application. FIG. 1A and FIG. 1B are schematic structural diagrams of a voltage protection apparatus according to an embodiment of this application. FIG. 2 is a schematic diagram of circuit connection of a voltage protection apparatus according to an embodiment of this application. FIG. 3 is a main view of a PCB according to an embodiment of this application. FIG. 4 is a cross-sectional view of a voltage protection apparatus according to an embodiment of this application. FIG. 5 is a schematic structural diagram of a system based on a voltage protection apparatus according to an embodiment of this application. A main view of the PCB shown in FIG. 4 shows only a through hole P1 and a conductive layer D, and other components on the PCB are not shown. FIG. 4 is a cross-sectional view of cutting the voltage protection apparatus along a plane corresponding to a dashed-line block M in FIG. 1A, FIG. 1B, and FIG. 5.

As shown in FIG. 1A, FIG. 1B, and FIG. 2 to FIG. 5, a voltage protection apparatus 10 includes: a metal housing 100, a printed circuit board PCB, a first connector 200, at least one varistor RV, and a high-voltage capacitor C. The at least one varistor RV is connected in series to and between a signal reference ground GND of the printed circuit board PCB and the first connector 200, and the high-voltage capacitor C is connected in series to and between the signal reference ground GND and the metal housing 100. The first connector 200, the at least one varistor RV, and the high-voltage capacitor C are fixed to the printed circuit board PCB, and the first connector 200 is a component for connecting the printed circuit board PCB to an external device 20. A cavity Q configured to accommodate the printed circuit board PCB is formed inside the metal housing 100, the printed circuit board PCB is fixed in the cavity Q, and a distance (L1, L2, L3, and L4 shown in FIG. 4) between any position on the printed circuit board PCB and any position on an inner surface of the metal housing 100 is greater than or equal to a corresponding electrical safety distance.

The at least one varistor RV and the high-voltage capacitor C disposed in the voltage protection apparatus implement floating-ground installation of the printed circuit board PCB. However, under different protection voltage requirements of the voltage protection apparatus, "at least one varistor RV and a high-voltage capacitor C" with different parameters may be set, so that the implementation of "floating-ground installation of the printed circuit board PCB" in this application is compared with the manner of "a spacing between the printed circuit board, the component, and the housing of the apparatus is increased with the increasing requirement of the protection voltage" in the related technology, thereby ensuring a less distance between the printed circuit board PCB and the metal housing 100.

The printed circuit board PCB may be set based on a function requirement of the voltage protection apparatus, and a corresponding component may be installed on the printed circuit board PCB based on the function requirement of the voltage protection apparatus, so as to meet the function requirement. For example, the voltage protection apparatus may be an apparatus installed on a wall of a corridor for accessing the network. The voltage protection apparatus may also be a switch or a server placed in an equipment room. The voltage protection apparatus may also be a transformer or a power distribution device disposed in a power distribution room. The voltage protection apparatus may also be a weak-current box in a weak-current well room, or the like.

A material of the metal housing may be a metal material that can conduct electricity, such as stainless steel or aluminum alloy. The material of the metal housing may be set based on a usage scenario, a function, and the like of the voltage protection apparatus, to meet different requirements.

In a possible implementation, the first connector 200 may include at least one network port connector and/or at least one plain old telephone service (Plain Old Telephone Service, POTS for short) connector. For example, the first connector 200 may be an RJ45 (Registered Jack 45), an RJ11, or the like. In this way, it can be ensured that all connectors that may be affected by a surge voltage can be protected.

When a quantity of first connectors 200 is greater than 1, the at least one varistor may be connected in series to and between the signal reference ground of the printed circuit board and one of the plurality of first connectors 200. Alternatively, a corresponding group of "at least one varistor and a high-voltage capacitor" may be disposed for at least two of the plurality of first connectors 200, each first connector 200 is connected in series to at least one corresponding varistor, and one end of each high-voltage capacitor is connected to at least one varistor corresponding to each first connector 200 respectively. Alternatively, a corresponding group of "at least one varistor" may be disposed for at least two of the plurality of first connectors 200, each first connector 200 is connected in series to at least one corresponding varistor, and the at least one varistor corresponding to each first connector 200 is connected to a same high-voltage capacitor. For example, it is assumed that the voltage protection apparatus 10 includes a first connector 201 and a second connector 202. In a first manner, a corresponding "varistor and high-voltage capacitor" may be disposed for any first connector, where the varistor is connected in series to and between the first connector 201 (or the second connector 202) and the GND, and the high-voltage capacitor is connected in series to and between the GND and 100. In a second manner, a corresponding "varistor and high-voltage capacitor" may be disposed for each first connector, that is, the "varistor and high-voltage capacitor" include RV1 and C1, RV2 and C2, where the RV1 is connected in series to and between the first connector 201 and the GND, and the C1 is connected in series to and between the GND and the 100. The RV2 is connected in series to and between the first connector 202 and the GND, and the C2 is connected in series to and between the GND and the 100. In a third manner, a corresponding "varistor" may be disposed for each first connector, that is, the varistor and the high-voltage capacitor of the apparatus include RV1, RV2, and C1. The RV1 is connected in series to and between the first connector 201 and the GND, the RV2 is connected in series to and between the first connector 201 and the GND, and the C1 is connected in series to and between the GND and the 100.

Other components may be further disposed on the printed circuit board PCB. For example, a power connector, a power adapter, a USB connector, an optical fiber flange, an SMA interface, and the like may be further disposed on the printed circuit board PCB, so that the printed circuit board PCB may be connected to an external device by using these connectors. A power button may be further disposed on the printed circuit board PCB, and is configured to turn on or off a power supply of the printed circuit board in response to a detected trigger operation. A reset button may be further disposed on the printed circuit board PCB, and is configured to control the printed circuit board to perform reset in response to a detected trigger operation.

In a possible implementation, an equivalent clamp voltage VR of the at least one varistor RV is less than or equal to a first divided voltage V1 on the printed circuit board PCB, an operating voltage VC of the high-voltage capacitor C is greater than or equal to a second divided voltage V2 between the signal reference ground GND and the metal housing 100, and a capacitance of the high-voltage capacitor ranges from 1 nF to 10 nF.

The equivalent clamp voltage VR and the operating voltage VC of the high-voltage capacitor C may be determined based on the following information: a protection voltage V0 of the voltage protection apparatus 10 determined based on a surge voltage or a lightning strike voltage that may occur in the voltage protection apparatus 10, where the voltage protection voltage may be 2 KV, 4 KV, or 6 KV; and a maximum voltage that can be borne by the PCB determined based on components in the PCB, that is, the first divided voltage V1. A minimum voltage that needs to be borne between the signal reference ground GND and the metal housing 100, that is, the second divided voltage V2, is determined based on the first connector and the like. In this way, $V_R \leq V1$, $V_C \geq V2$, and $V_R + V_C = V_0$.

A quantity of varistors RV in the voltage protection apparatus 10 may be one or more. If there is one varistor RV in the voltage protection apparatus 10, an equivalent clamp voltage $V_R$ of the at least one varistor RV may be a voltage value (which may be a clamp voltage) of a selected varistor. If there are a plurality of varistors RV in the voltage protection apparatus 10, the plurality of varistors RVs are connected in series and/or in parallel, and the plurality of varistors RV connected in series and/or in parallel are connected in series to and between the signal reference ground GND and the first connector 200. The equivalent clamp voltage $V_R$ of the at least one varistor RV may be equivalent voltages of the plurality of varistors that are determined based on a connection relationship between the plurality of varistors RV and voltage values (which may be nominal voltages) of the varistors. In this way, a quantity of varistors may be selected based on an actual requirement, and a connection manner between the plurality of varistors may be set. For example, costs of varistors with different clamp voltages and requirements of the equivalent clamp voltage may be comprehensively considered, cost differences between one varistor and a plurality of varistors are compared, and one varistor or the plurality of varistors with lower costs are selected.

In a possible implementation, the apparatus further includes a fastener, a material of the fastener is a conductive material, a protruding portion 101 located in the cavity Q is disposed on the metal housing 100, and the fastener is configured to fasten the printed circuit board PCB to the protruding portion 101. One end of the high-voltage capacitor C is connected to the signal reference ground GND, and the other end of the high-voltage capacitor C is disposed in an area in which the printed circuit board PCB is in contact with the fastener, or the other end of the high-voltage capacitor C extends, by using a wire, to an area in which the printed circuit board PCB is in contact with the fastener, so that the other end of the high-voltage capacitor C is indirectly connected to the metal housing 100 by using the fastener. In this way, the other end of the high-voltage capacitor C may be connected to the metal housing 100 by using the fastener, and there is no need to separately dispose a "wire" for implementing the connection between the other end of the high-voltage capacitor C and the metal housing 100, thereby reducing costs of the apparatus and simplifying structural setting of the apparatus. In addition, compared with the separately disposed "wire", the fastener has higher reliability, and can further improve reliability of the apparatus.

The fastener may be various types of bolts, screws, and horns, or may be another component that can fasten the PCB to the protruding portion 101. This is not limited in this application. The protruding portion 101 and the metal housing 100 may be an integrally formed structure, or the protruding portion 101 may be fastened to the metal housing 100 through welding, connection by using a fastener, or the like. This is not limited in this application.

In a possible implementation, as shown in FIG. 1B, FIG. 3, and FIG. 4, the fastener may include a screw or a bolt 300, a through hole P1 is provided on the printed circuit board PCB, and an inner wall of the through hole P1 is covered with a conductive layer D. A screw hole (for example, 1011) or a bottom hole is provided on the protruding portion 101, and the screw or the bolt 300 is screwed into the screw hole (for example, 1011) or the bottom hole through the through hole P1. The other end of the high-voltage capacitor C is connected to the conductive layer D directly or by using the wire, so that the other end of the high-voltage capacitor C is indirectly connected to the metal housing 100 by using the conductive layer D, the screw, or the bolt 300. In this way, the printed circuit board is fixed and the other end of the high-voltage capacitor is connected to the metal housing by using the screw or the bolt. The bolt or the screw is more convenient for the user to install and remove the printed circuit board. In addition, the "bolt or screw" and the "through hole with a conductive layer disposed on the printed circuit board" are disposed, which further simplifies the structure setting of the apparatus. Because the bolt and the screw can be processed and manufactured by using an existing processing process, a manufacturing process of the apparatus can be simplified.

In a possible implementation, as shown in FIG. 1A, FIG. 1B, FIG. 4, and FIG. 5, a connection line hole 102 communicating with the cavity Q is provided on the metal housing 100, so that a connection line 30 of the external device 20 connected to the printed circuit board PCB is connected to the first connector 200 through the connection line hole 102. A quantity and a size of the connection line hole 102 may be configured based on a quantity of the external devices 20 that can be connected to the printed circuit board PCB and the size of the connection line 30 used by each external device 20, so as to ensure that when the printed circuit board PCB is connected to all the external devices 20 that can be connected to the printed circuit board PCB, the connection line hole 102 disposed on the metal housing 100 can accommodate the connection lines 30 of all the external devices 20. The connection line hole 102 may be disposed on a side surface (for example, a bottom surface) of the metal housing 100. The connection line hole 102 may be a rectangular hole shown in FIG. 1A, FIG. 1B, FIG. 4, or FIG. 5, or may be a hole of another shape such as a circle or an ellipse. This is not limited in this application.

In a possible implementation, a port of the first connector 200 for connecting to the external device 20 may be directly installed at the connection line hole 102, so that the connection line 30 connected to the external device 20 of the printed circuit board PCB is directly connected, in a plug-in manner, to the first connector 200 disposed at the connection line hole 102.

In this application, the electrical safety distance may be determined based on a protection requirement such as a protection voltage of the voltage protection apparatus. The electrical safety distance includes, in addition to a distance (L1, L2, L3, and L4 shown in FIG. 4) between any position on the PCB and any position on the inner surface of the metal housing 100, a keep-out area (as shown in FIG. 3) of the through hole P1 on the PCB, a distance between pins of a component installed on the PCB, a distance between an antenna feeder on the PCB and the through hole P1, a distance between a pin of a component installed on the PCB and any position on the metal housing, and a distance between the GND on the PCB and the through-hole P1, and the like. In a related technology, if a protection voltage is 6 KV, a radius of a keep-out area of the through hole P1 on the PCB may be 300 mil to meet a protection requirement. However, in the voltage protection apparatus provided in this application, a radius of a keep-out area of the through hole P1 on the PCB may be 140 mil to meet a protection requirement (for a protection requirement, refer to a detection result in the following example), and a design of a same protection voltage requirement can be met only when a radius of the keep-out area is 300 mil.

In a possible implementation, the metal housing 100 includes a body 100-1 and a cover body 100-2. When the cover body 100-2 is in a closed state (referring to the states shown in FIG. 1A and FIG. 5) relative to the body 100-1, the cover body 100-2 and the body 100-1 form the sealed cavity Q inside. When the cover body 100-2 is in an open state (referring to a state shown in FIG. 1B, where the cover body 100-2 is not shown in the voltage protection apparatus shown in FIG. 1B) relative to the body 100-1, at least the first connector 200 is located in an operable space relative to the body 100-1, where the operable space includes an external space relative to the body 100-1 and/or an internal space Q-1 of the body 100-1 (referring to FIG. 4), so as to facilitate a connection between the external device 20 and the first connector 200 in the operable space.

As shown in FIG. 4, the PCB includes a first surface S1 and a second surface S2 that are disposed opposite to each other, and components such as a first connector on the PCB may be installed and fixed on the first surface S1. When the cover body 100-2 is in an open state (referring to the state shown in FIG. 1B) relative to the body 100-1, the first surface S1 of the PCB is in the operable space, so that the user can use and maintain the voltage protection apparatus.

In a possible implementation, the cover body 100-2 and the body 100-1 are connected by using a hinge, so that the cover body 100-2 and the body 100-1 can rotate relative to each other. The user may open or close the metal housing 100 by operating the cover body 100-2. By disposing the metal housing as two parts: the cover body and the body, the user may open or close the metal housing 100 by operating the cover body 100-2, so as to perform operations such as maintaining the voltage protection apparatus 10 and connecting to an external device. Alternatively, the cover body 100-2 and the body 100-1 may also be detachably and fixedly connected by using a fastener, so that the user can open or close the metal housing 100 by disassembling the fastener that fixes the cover body 100-2 and the body 100-1. Alternatively, the cover body 100-2 and the body 100-1 may be fixedly connected in a clamping manner, so that the user can open or close the metal housing 100 by disassembling the cover body 100-2. A person skilled in the art may set a fixed connection manner between the cover body 100-2 and the body 100-1 based on an actual requirement. This is not limited in this application.

In a possible implementation, the body 100-1 is provided with the connection line hole 102 and/or the protruding portion 101. In this way, after the user opens the metal housing, the portions that can be maintained and operated by the user, such as the printed circuit board, are all located in the body, so that the user can conveniently use and maintain the voltage protection apparatus.

FIG. 6A and FIG. 6B are schematic structural diagrams of a protruding portion according to an embodiment of this application. A shape of the protruding portion 101 may be an "L" shape shown in FIG. 4, or may be a "T" shape shown in FIG. 6A, a shape similar to "C" shape shown in FIG. 6B, or the like. A person skilled in the art may set a shape of the protruding portion 101 based on an actual requirement. This is not limited in this application. In addition, there may be a plurality of protruding portions 101 disposed on the metal housing 100 as shown in FIG. 4, or there may be one protruding portion 101 (not shown in the figure). In addition, when there are a plurality of protruding portions 101, the plurality of protruding portions 101 may be fixedly connected together, thereby improving stability of the printed circuit board PCB after installation.

This application further provides a system based on a voltage protection apparatus. As shown in FIG. 5, the system includes:

the voltage protection apparatus 10; and
an external device 20, where the external device 20 is connected to the printed circuit board PCB of the protection apparatus by using the first connector 200 of the voltage protection apparatus 10.

In a possible implementation, a connection line 30 of the external device 20 is connected to the first connector 200 through the connection line hole 102 of the voltage protection apparatus 10.

The following uses Example 1 as an example of the voltage protection apparatus 10 provided in this application for description, so as to more intuitively understand the voltage protection apparatus 10 provided in this application.

Example 1:

It is assumed that basic information of a voltage protection apparatus 10 to be manufactured includes that:

The protection voltage $V_0$ is 6 KV

A network port transformer is fixed and installed on the printed circuit board PCB, and a maximum voltage that the network port transformer can withstand is 2.5 KV

The first connector installed and fixed on the printed circuit board PCB is a POTS connector, and a clamp voltage of a transient voltage suppressor (Transient Voltage Suppressor, TVS for short) of the POTS connector is 145 V

A rising time t of the surge/lightning voltage is 10 $\mu$s, and duration is 700 $\mu$s.

In this case, it may be determined, based on the basic information, that the first divided voltage V1 is 2.5 KV The second divided voltage V2 is 3.855 KV (V2=4 KV-145 V). Because $V_0$=6 KV, $V_R$=2 KV and Vc=4 KV may be set. $V_R$+$V_C$=2 KV+4 KV=$V_0$=6 KV In this way, three 620 V/4500 A varistors may be selected, and the three varistors are connected in series and then connected in series to and between the first connector 200 and the signal reference ground GND. Due to the surge or lightning voltage, a charging current I of the high-voltage capacitor C is about 10 mA (

$$I = C \times \frac{dV_C}{dt}$$

). The voltage is clamped to 700 V by the varistor. The three varistors RV are connected in series with a divided voltage of 2.1 KV The high-voltage capacitor C may be a 6000 V/1 nF high-voltage capacitor

Then, the design of the voltage protection apparatus is completed by setting the electrical safety distance with reference to the protection voltage of 6 KV In addition, the designed voltage protection apparatus is determined to completely meet the protection requirements through a design check.

In addition, to test the performance of the voltage protection apparatus provided in this application, after the setting and selection of the varistor and the high-voltage voltage are completed, the electrical safety distance is set to 140 mil with reference a protection voltage being 4 KV Then, the design check is performed on the set voltage protection apparatus, and whether each part of the voltage protection apparatus meets the electrical safety distance requirement is determined. The check record is shown in Table 1. Referring to the following Table 1, it can be intuitively seen that even if the apparatus provided in this application is set according to an electrical safety distance of a protection voltage of 4 KV, the apparatus can still meet a partial protection requirement of a protection voltage of 6 KV That is, the voltage protection apparatus provided in this application is designed based on a low protection voltage, and the obtained voltage protection apparatus can meet a requirement of a higher protection voltage.

**Table 1 Design check records of a voltage protection apparatus**

| Number | Category | Floating ground design check items | 6KV protection requirement | 4 KV protection requirement |
|---|---|---|---|---|
| | Set on a PCB | Distance between a GND pin of a power connector and a first surface S1 of the PCB | Inconformity | Conformity |
| | | Distance between the GND pin of the power connector and a second surface S2 of the PCB | Conformity | Conformity |
| | | Distance between a tail connector and the PCB after a power adapter is inserted | Inconformity | Conformity |
| | | Distance between a power button pin and the PCB | Inconformity | Conformity |
| | | Distance between the power button pin and the second surface S2 of the PCB | Conformity | Conformity |
| | | Distance between the power button pin and a through hole P1 | Inconformity | Conformity |
| | | Distance between a reset button pin and the PCB | Inconformity | Conformity |
| | | Distance between the reset button pin and the second surface S2 of the PCB | Conformity | Conformity |
| | | Distance between the reset button pin and the through hole P1 | Conformity | Conformity |
| | | Distance between a LAN connector pin and the PCB | Conformity | Conformity |
| | | Distance between the LAN connector pin and the second surface S2 of the PCB | Conformity | Conformity |
| | | Distance between a POTS connector pin and the PCB | Inconformity | Conformity |
| | | Distance between a center of an antenna installation hole and the through hole P1 | Inconformity | Conformity |
| | Bottom portion of the metal housing 100 | Distance between a surface-mounted component on the PCB bottom surface and the bottom portion of the 100 | Inconformity | Conformity |
| | | Distance between a shielding cover on the PCB bottom surface and the bottom portion of the 100 | Inconformity | Conformity |
| | | Distance between the plug-in component pin on the PCB bottom surface and the bottom portion of the 100 | Inconformity | Conformity |
| | Top portion of the metal housing 100 | Distance between the surface-mounted component on the PCB top surface and the top portion of the 100 | Conformity | Conformity |
| | | Distance between the plug-in component on the PCB top surface and the top portion of the 100 | Conformity | Conformity |

(continued)

| Number | Category | Floating ground design check items | 6KV protection requirement | 4 KV protection requirement |
|---|---|---|---|---|
| | | Distance between the shielding cover on the PCB top surface and the top portion of the 100 | Conformity | Conformity |
| | | Distance between a heat sink on the PCB top surface and the top portion of the 100 | Inconformity | Conformity |
| | Periphery of the metal housing 100 | Distance between a PCB GND and the surrounding of the metal housing 100 | Inconformity | Conformity |
| | Inside PCB board | Distance between the PCB GND and the through hole P1 | Inconformity | Conformity |
| | | Distance between two pins of a high-voltage capacitor | Inconformity | Conformity |
| | | Distance between an antenna feeder on the PCB and the through hole P1 | Inconformity | Conformity |
| | | Distance between the antenna feeder on the PCB and each position of the metal housing 100 | Inconformity | Conformity |

The flowcharts and the block diagrams in the accompanying drawings illustrate system architectures, functions, and operations of possible implementations of apparatuses, systems, methods, and computer program products according to a plurality of embodiments of this application. In this regard, each block in the flowcharts or the block diagrams may represent a module, a program segment, or a part of the instructions, where the module, the program segment, or the part of the instructions includes one or more executable instructions for implementing a specified logical function. In some alternative implementations, the functions marked in the blocks may also occur in a sequence different from that marked in the accompanying drawings. For example, two consecutive blocks may actually be executed substantially in parallel, and sometimes may be executed in a reverse order, depending on a function involved.

It should also be noted that each block in the block diagrams and/or the flowcharts and a combination of blocks in the block diagrams and/or the flowcharts may be implemented by hardware (for example, a circuit or an ASIC (Application Specific Integrated Circuit, application-specific integrated circuit)) that performs a corresponding function or action, or may be implemented by a combination of hardware and software, for example, firmware.

Although the present invention is described with reference to embodiments, in a process of implementing the present invention that claims protection, a person skilled in the art may understand and implement another variation of the disclosed embodiments by viewing the accompanying drawings, the disclosed content, and the accompanying claims. In the claims, "comprising" (comprising) does not exclude another component or another step, and " a" or "one" does not exclude a case of multiple. A single processor or another unit may implement several functions enumerated in the claims. Some measures are recorded in dependent claims that are different from each other, but this does not mean that these measures cannot be combined to produce better effect.

Embodiments of this application are described above. The foregoing descriptions are examples, are not exhaustive, and are not limited to the disclosed embodiments. Without departing from the scope of the described embodiments, many modifications and variations are apparent to a person of ordinary skill in the technical field. The selection of terms used in this specification is intended to best explain the principles of embodiments, practical application, or improvements to technologies in the market, or to enable another person of ordinary skill in the art to understand embodiments disclosed in this specification.

**Claims**

1. A voltage protection apparatus, wherein the apparatus comprises a metal housing, a printed circuit board, a first connector, at least one varistor, and a high-voltage capacitor, wherein

the at least one varistor is connected in series to and between a signal reference ground of the printed circuit board and the first connector, and the high-voltage capacitor is connected in series to and between the signal reference ground and the metal housing;

the first connector, the at least one varistor, and the high-voltage capacitor are fixed to the printed circuit board, and the first connector is a component for connecting the printed circuit board to an external device; and

a cavity configured to accommodate the printed circuit board is formed inside the metal housing, the printed circuit board is fixed in the cavity, and a distance between any position on the printed circuit board and any position on an inner surface of the metal housing is greater than or equal to an electrical safety distance.

2. The apparatus according to claim 1, wherein if there are a plurality of varistors, the plurality of varistors are connected in series and/or in parallel, and the plurality of varistors connected in series and/or in parallel are connected in series to and between the signal reference ground and the first connector

3. The apparatus according to claim 1, wherein an equivalent clamp voltage of the at least one varistor is less than or equal to a first divided voltage on the printed circuit board, an operating voltage of the high-voltage capacitor is greater than or equal to a second divided voltage between the signal reference ground and the metal housing, and a capacitance of the high-voltage capacitor ranges from 1 nF to 10 nF.

4. The apparatus according to claim 1, wherein the apparatus further comprises a fastener, and a material of the fastener is a conductive material;

a protruding portion located in the cavity is disposed on the metal housing, and the fastener is configured to fasten the printed circuit board to the protruding portion; and

one end of the high-voltage capacitor is connected to the signal reference ground, and the other end of the high-voltage capacitor is disposed in an area in which the printed circuit board is in contact with the fastener, or the other end of the high-voltage capacitor extends, by using a wire, to an area in which the printed circuit board is in contact with the fastener, so that the other end of the high-voltage capacitor is indirectly connected to the metal housing by using the fastener

5. The apparatus according to claim 4, wherein the fastener comprises a screw or a bolt, a through hole is provided on the printed circuit board, and an inner wall of the through hole is covered with a conductive layer;

a screw hole or a bottom hole is provided on the protruding portion, and the screw or the bolt is screwed into the screw hole or the bottom hole through the through hole; and

the other end of the high-voltage capacitor is connected to the conductive layer directly or by using the wire, so that the other end of the high-voltage capacitor is indirectly connected to the metal housing by using the conductive layer and the fastener.

6. The apparatus according to claim 1, wherein the first connector comprises at least one network port connector and/or at least one plain old telephone service connector

7. The apparatus according to claim 1, wherein a connection line hole communicating with the cavity is provided on the metal housing, so that a connection line of the external device connected to the printed circuit board is connected to the first connector through the connection line hole.

8. The apparatus according to any one of claims 1 to 7, wherein the metal housing comprises a body and a cover body, wherein

when the cover body is in a closed state relative to the body, the cover body and the body form the sealed cavity inside; and

when the cover body is in an open state relative to the body, at least the first connector is located in an operable space relative to the body, wherein the operable space comprises an external space relative to the body and/or an internal space of the body, so as to facilitate a connection between the external device and the first connector in the operable space.

9. The apparatus according to claim 8, wherein the body is provided with the connection line hole and/or the protruding portion.

10. A system based on a voltage protection apparatus, comprising:

the voltage protection apparatus according to any one of claims 1 to 9; and

an external device, wherein the external device is connected to the printed circuit board of the protection apparatus by using the first connector of the voltage protection apparatus.

11. The system according to claim 10, wherein a connection line of the external device is connected to the first connector through the connection line hole of the voltage protection apparatus.

FIG. 1A

FIG. 1B

FIG. 2

FIG. 3

FIG. 4

FIG. 5

FIG. 6A

FIG. 6B

## INTERNATIONAL SEARCH REPORT

| | International application No. |
|---|---|
| | **PCT/CN2022/092881** |

| A. | CLASSIFICATION OF SUBJECT MATTER |
|---|---|

H02H 9/04(2006.01)i

According to International Patent Classification (IPC) or to both national classification and IPC

| B. | FIELDS SEARCHED |
|---|---|

Minimum documentation searched (classification system followed by classification symbols)

H02H; H05K; H01R

Documentation searched other than minimum documentation to the extent that such documents are included in the fields searched

Electronic data base consulted during the international search (name of data base and, where practicable, search terms used)

CNTXT, ENTXT, ENTXTC, DWPI, WPABS, CNKI: 参考地, 信号地, 接地, 变阻器, 压敏电阻连接器, 电容, 印刷电路板, PCB, 印制电路板, 壳, ground, earth, MOV, varistor, connector, capacity, printed circuit board, house, shell, cas+

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | CN 112351579 A (ANHUI YANSHI TECH CO., LTD.) 09 February 2021 (2021-02-09) description, paragraphs 27-41 and figures 1-4 | 1-11 |
| Y | CN 201663238 U (HEBEI WEIAO ELECTRONIC TECHNOLOGY CO., LTD.) 01 December 2010 (2010-12-01) description, paragraphs 21-25 and figures 1-4 | 1-11 |
| Y | CN 106922080 A (SHANGHAI GANSHI COMMUNICATION TECHNOLOGY CO., LTD.) 04 July 2017 (2017-07-04) description, paragraphs 23-44 and figures 1-3 | 1-11 |
| Y | CN 110739673 A (CYBER POWER SYSTEMS, INC.) 31 January 2020 (2020-01-31) description, paragraphs 14-32 and figures 1-7 | 1-11 |
| A | CN 102735362 A (BEIJING RESEARCH INSTITUTE OF TELEMETRY et al.) 17 October 2012 (2012-10-17) entire document | 1-11 |
| A | US 2003068926 A1 (SIEMENS VDO AUTOMOTIVE CORP.) 10 April 2003 (2003-04-10) entire document | 1-11 |

☐ Further documents are listed in the continuation of Box C.　　☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **14 July 2022** | **25 July 2022** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/092881**

| Patent document cited in search report | | | Publication date (day/month/year) | Patent family member(s) | | | Publication date (day/month/year) |
|---|---|---|---|---|---|---|---|
| CN | 112351579 | A | 09 February 2021 | None | | | |
| CN | 201663238 | U | 01 December 2010 | None | | | |
| CN | 106922080 | A | 04 July 2017 | None | | | |
| CN | 110739673 | A | 31 January 2020 | CN | 110739673 | B | 14 December 2021 |
| CN | 102735362 | A | 17 October 2012 | CN | 102735362 | B | 02 April 2014 |
| US | 2003068926 | A1 | 10 April 2003 | WO | 03032448 | A1 | 17 April 2003 |
| | | | | DE | 10297257 | T5 | 10 March 2005 |
| | | | | JP | 2005506661 | A | 03 March 2005 |
| | | | | US | 6699076 | B2 | 02 March 2004 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110510999